# EUROPÄISCHE PATENTSCHRIFT

(11) **EP 0 459 313 B1**
(45) Veröffentlichungstag und Bekanntmachung des Hinweises auf die Patenterteilung: **18.09.1996**
(21) Anmeldenummer: 91108419.2
(22) Anmeldetag: 24.05.1991
(51) Int. Cl.: H03K 5/24

(54) **Komparatorschaltung für einen Integrator**
Comparator circuit for an integrator
Circuit comparateur pour intégrateur

(30) Priorität: 01.06.1990 DE 4017738
(43) Veröffentlichungstag der Anmeldung: 04.12.1991
(73) Patentinhaber: DEUTSCHE THOMSON-BRANDT GMBH, 78048 Villingen-Schwenningen (DE)
(72) Erfinder: Koblitz, Rudolf, Dr.-Ing., W-7730 Villingen (DE); Lenz, Kuno, Dipl.-Ing., W-7730 Villingen (DE)
(74) Vertreter: Hartnack, Wolfgang, Dipl.-Ing.

(56) Entgegenhaltungen:
- DE-A- 1 921 213
- GB-A- 1 152 488
- US-A- 3 098 939
- FUNKSCHAU, Heft 8, 1972, Seiten 764-766, L. WALZ: "Geregelte Impulsgeneratoren für Halbleiter-Zeilen-Endstufen"
- VALVO Schaltungssammlung 16.Feb.1970, Nr. 23

## Beschreibung

Die Erfindung betrifft eine Komparatorschaltung für einen Integrator.

### Stand der Technik

In vielen elektrischen Schaltungen ist es erforderlich, den Pegel von Signalen zu detektieren und in Abhängigkeit von der momentanen Höhe dieses Pegels Ausgangssignale in ihrem Logik-Pegel zu verändern, z.B. für Rampenfunktions-Generatoren unter Verwendung eines Integrators.
Die Komparator-Funktion kann mit integrierten Komparatoren gebildet werden, z.B. mit dem Typ LM 111 des Herstellers National Semiconductor und die Integratorfunktion z.B. mit einem Operationsverstärker vom Typ 741 oder mit einem rückgekoppelten Transistor. Eine Kombination aus beiden kann auf einem Chip integriert sein.
Normalerweise muß aber für eine definierte Betriebsweise des Komparators dessen Eingangsspannung in einem Bereich von ca. 1-2 V über dem Massepotential und ca. 1-2 V unter der Betriebsspannung liegen. Der ausnutzbare Eingangsspannungsbereich ist also bezogen auf die Betriebsspannung deutlich begrenzt.

Es gibt zwar Komparatoren, z.B. Typ LM 193 des Herstellers National Semiconductor, bei denen die Eingangsspannung bis zum Massepotential nutzbar ist. Doch die obere Grenze des Eingangsspannungsbereiches liegt auch bei diesem Typ ca. 1-2 V unter der Betriebsspannung.
Außerdem sind die Schaltungen für solche bekannten Komparatoren relativ aufwendig und es würde für eine integrierte Komparatorschaltung für einen Integrator eine relativ große Chipfläche benötigt.

### Erfindung

Der Erfindung liegt die Aufgabe zugrunde, für einen Integrator eine Komparatorschaltung mit erweitertem Eingangsspannungsbereich und reduziertem Schaltungsaufwand anzugeben.

Diese Aufgabe wird durch die im Patentanspruch 1 angegebenen Merkmale gelöst. Vorteilhafte Weiterbildungen der Erfindung sind in den abhängigen Ansprüchen beschrieben.

In der erfindungsgemäßen Komparatorschaltung wird die Sättigung von durch den Integrator angesteuerten komplementären Transistoren so ausgenutzt, daß die Komparatorausgänge erst bei Erreichen der Sättigungsspannungen schalten. Die entsprechende Sättigungsspannung VCEsat der komplementären Transistoren beträgt jeweils ca. 50 mV. Es können z.B. zwei Komparatorausgänge vorgesehen sein. Der eine Ausgang ändert seinen Logikpegel, wenn die Eingangsspannung der Komparatorschaltung einen ersten Schwellwert (Massepotential + VCEsat) erreicht und der andere Ausgang, wenn die Eingangsspannung der Komparatorschaltung einen zweiten Schwellwert (Betriebsspannung - VCEsat) erreicht.
Der Ausgangstransistor für den ersten Schwellwert wird z.B. durch einen NPN-Transistor angesteuert und der Ausgangstransistor für den zweiten Schwellwert durch einen PNP-Transistor.

### Zeichnungen

Nachstehend wird ein Ausführungsbeispiel der Erfindung anhand von Zeichnungen erläutert. Diese zeigen in
- Fig. 1: eine bekannte Komparatorschaltung für einen Integrator,
- Fig. 2: eine erfindungsgemäße Komparatorschaltung für einen Integrator.
- Fig. 3: Strom- und Spannungsdiagramm der Komparatorschaltung, wenn Strom in den Eingang 24 fließt
- Fig. 4: Strom- und Spannungsdiagramm der Komparatorschaltung, wenn Strom aus dem Eingang 24 fließt

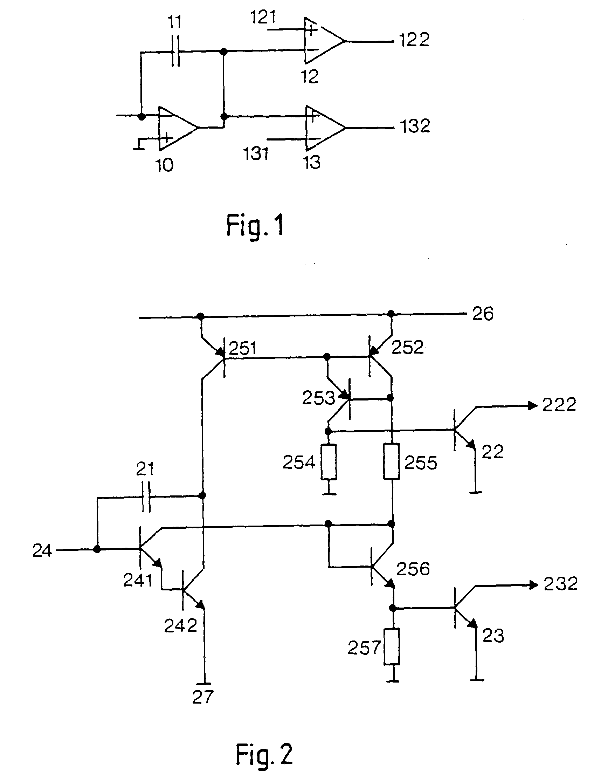

In Fig. 1 ist ein Integrator, bestehend aus einem Verstärker 10 und einem Integrations-Kondensator 11, dargestellt. An den Ausgang dieses Integrators sind zwei Differenzverstärker 12 und 13 angeschlossen. Diese sind an eine Betriebsspannung 26 (Vcc) und an Massepotential 27 angeschlossen. An einem Eingang 131 des ersten Differenzverstärkers 13 liegt die Referenzspannung Vlow an und an einem Eingang 121 des zweiten Differenzverstärkers 12 die Referenzspannung Vhigh. Vhigh am Eingang 121 des zweiten Differenzverstärkers 12 kann dann z.B. einen maximalen Wert (Vcc-2V) annehmen und Vlow am Eingang 131 des ersten Differenzverstärkers 13 kann z.B. einen minimalen Wert (Massepotential+1V) annehmen.
Der maximale Komparator-Eingangsspannungshub ist also 2 bis 3V niedriger als die Betriebsspannung 26 und eine entsprechende integrierte Kombination von Integrator und Komparatoren benötigt eine relativ große Chipfläche.

### Ausführungsbeispiele

Fig. 2 zeigt einen Integrator, der aus den Transistoren 241 und 242 und aus dem Integrations-Kondensator 21 besteht. Der Integrator wird mit einem Strom am Eingang 24 angesteuert und erhält seinen Versorgungsstrom aus einem als Stromspiegel geschalteten Transistor 251. Dieser liefert ein Abbild des Stromes der Stromquelle mit Transistor 252.
Der Integrations-Kondensator 21 ist ebenfalls an die gespiegelte Stromquelle mit Transistor 251 angeschlossen.
Wenn ein Strom in den Eingang 24 fließt, dann sinkt die Spannung am Knoten mit den Transistoren 251 und 242 und Integrations-Kondensator 21, weil dieser Kondensator entladen wird. Die Spannung an diesem Knoten nähert sich zunehmend dem Wert null. Dieser Vorgang ist beendet, wenn Transistor T 242 gesättigt ist und eine Sättigungsspannung zwischen Kollektor und Emitter von ca. 50 mV hat. Es fließt dadurch ein Basisstrom in Transistor 242. Dieser Basisstrom fließt auch durch den Kollektor von Transistor 241 und wird aus Widerstand 255 entnommen und fließt daher nicht in Transistor 256. Dadurch fällt die Spannung an Widerstand 257 und Transistor 23 sperrt. Wenn weiter Strom in den Eingang 24 fließt, sättigt auch Transistor 241, sodaß dieser Strom vorteilhaft nicht in den Integrations-Kondensator 21 fließt, sondern in die Basis von Transistor 241. Der untere Pegel der Spannung am obengenannten Knoten 251, 242 und 21 wird somit durch den sperrenden Transistor 23 detektiert. Der Strom durch Transistor 252 wird vorteilhaft nur geringfügig durch die Spannungsschwankung am Kollektor von Transistor 241 beeinflußt, wenn Transistor 241 sättigt.
Fließt ein Strom aus dem Eingang 24 heraus, dann steigt die Spannung am Knoten mit den Transistoren 251 und 242 und Integrations-Kondensator 21, weil dieser Kondensator geladen wird. Die Spannung an diesem Knoten nähert sich zunehmend der Betriebsspannung 26 (Vcc). Dieser Vorgang ist beendet, wenn Transistor T 251 gesättigt ist und eine Sättigungsspannung zwischen Kollektor und Emitter von ca. 50 mV hat. Es fließt dadurch ein Basisstrom in Transistor 251. Dieser Basisstrom wird durch den Kollektor von Transistor 253 und weiter durch den Widerstand 254 geliefert. Dadurch steigt die Spannung an Widerstand 254 und Transistor 22 wird leitend. Der obere Pegel der Spannung am obengenannten Knoten 251, 242 und 21 wird somit durch den leitenden Transistor 22 detektiert.
Auf diese Weise kann für den Komparator vorteilhaft ein Spannungsbereich von (Vcc-2*VCEsat) genutzt worden.

Durch den geringen Schaltungsaufwand des mit dem Integrator verknüpften Komparators ist die dafür benötigte Chipfläche beim Integrieren vorteilhaft klein und der Versorgungsstrom für diese Schaltung vorteilhaft niedrig.

Werden die Komparatorausgänge 222 und 232 z.B. benutzt, um jeweils eine Stromquelle umzupolen und wird diese Stromquelle nur dem Eingang 24 angeschlossen, entsteht ein Rampenfunktions-Generator. Dessen Ausgangsspannung ist am Verbindungspunkt von Integrations-Kondensator 21 und den Transistoren 242 und 251 abgreifbar.

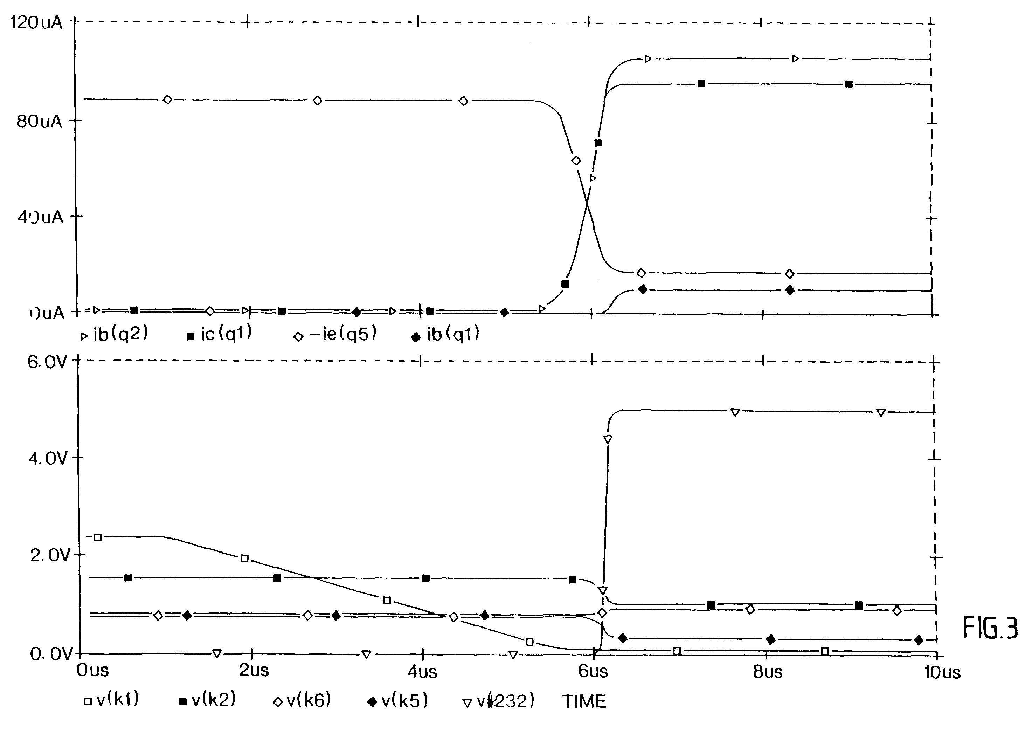

In Fig. 3 sind einige zeitliche Strom- und Spannungsverläufe in der Komparatorschaltung nach Fig. 2 für den Fall eines in den Eingang 24 fließenden Stromes dargestellt. Dabei bedeuten:
- ib(q2) Basisstrom von Transistor 242
- ic(q1) Kollektorstrom von Transistor 241
- ie(q5) Emitterstrom von Transistor 256
- ib(q1) Basisstrom von Transistor 241
- v(k1) Spannung an Kollektor von Transistor 242
- v(k2) Spannung an Kollektor von Transistor 256
- v(k6) Spannung an Basis von Transistor 242
- v(k5) Spannung an Basis von Transistor 23
- v(k232) Spannung an Kollektor von Transistor 23, wenn dieser über einen Widerstand mit der Betriebsspannung 26 verbunden ist

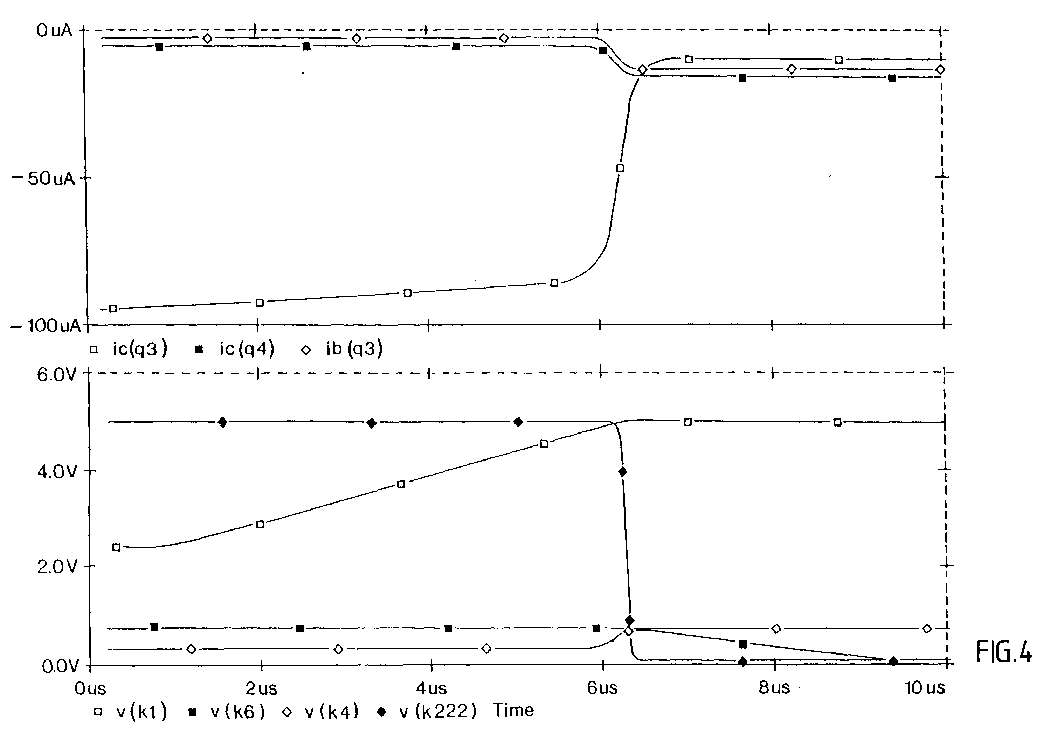

In Fig. 4 sind einige zeitliche Strom- und Spannungsverläufe in der Komparatorschaltung nach Fig. 2 für den Fall eines aus dem Eingang 24 fließenden Stromes dargestellt. Dabei bedeuten:
- ic(q3) Kollektorstrom von Transistor 251
- ic(q4) Kollektorstrom von Transistor 253
- ib(q3) Basisstrom von Transistor 251
- v(k1) Spannung an Kollektor von Transistor 242
- v(k6) Spannung an Basis von Transistor 242
- v(k4) Spannung an Basis von Transistor 22
- v(k222) Spannung an Kollektor von Transistor 22, wenn dieser über einen Widerstand mit der Betriebsspannung 26 verbunden ist

Hat Vcc beispielsweise einen Wert von 5V, so ist der nutzbare Spannungshub (5V-2*0,05V) = 4,9V. Damit läßt sich bei entsprechender Größe des Integrations-Kondensators 21 eine Rampenfunktion mit einer Periodendauer von beispielsweise 10 µs realisieren.

In einer entsprechenden bekannten Schaltung kann z.B. nur ein Spannungshub von (Vcc-2,5V) = 2,5V ausgenutzt werden. Um eine Rampenfunktion mit gleicher Periodendauer zu realisieren, müßte der Integrations-Kondensator 21 annähernd den doppelten Wert haben und würde entsprechend eine annähernd doppelte Chipfläche benötigen.

## Patentansprüche

1. Komparatorschaltung (22, 23, 254, 256, 257) mit einem Integrator (21, 242) und :
- einem aus einer Stromquelle (252) gespeisten, an einen Pol (26) der Versorgungsspannung angeschlossenen und in die Sättigungsspannung steuerbaren ersten Transistor (251), dessen Ausgang einem Anschluß eines Kondensators (21) und einem Ausgang eines zweiten, an den anderen Pol (27) der Versorgungsspannung angeschlossenen und in die Sättigungsspannung steuerbaren Transistors (242) zugeordnet ist,
- einem Integrator-Eingang (24), der dem anderen Anschluß des Kondensators (21) und dem Eingang eines dritten Transistors (241) zugeordnet ist, dessen einer Ausgang dem Eingang des zweiten Transistors (242) zugeordnet ist und dessen anderer Ausgang dem Eingang der Komparatorschaltung und dem Eingang der mit der Komparatorschaltung verbundenen Stromquelle (252) zugeordnet ist.

2. Komparatorschaltung nach Anspruch 1, **dadurch gekennzeichnet,** daß der erste Transistor (251) und der zweite Transistor (242) während des Ladens und Entladens des Kondensators (21) ungesättigt sind.

3. Komparatorschaltung nach Anspruch 1 oder 2, **dadurch gekennzeichnet,** daß der erste Transistor (251) und der zweite Transistor (242) komplementäre Transistoren sind.

4. Komparatorschaltung nach Anspruch 1, 2 oder 3, **dadurch gekennzeichnet,** daß der erste Transistor (251) die Funktion eines Stromspiegels hat.

5. Komparatorschaltung nach einem oder mehreren der Ansprüche 1 bis 4, **dadurch gekennzeichnet,** daß der erste Transistor (251) vom Typ PNP und der zweite (242) und dritte (241) Transistor vom Typ NPN sind, wobei der Kollektor des ersten Transistors dem Kollektor des zweiten Transistors und der Kollektor des dritten Transistors der Komparatorschaltung zugeordnet ist.

6. Komparatorschaltung nach einem oder mehreren der Ansprüche 1 bis 5, **dadurch gekennzeichnet,** daß der Integrator einen stromgesteuerten Eingang (24) hat.

7. Komparatorschaltung nach Anspruch 6, **dadurch gekennzeichnet,** daß die Komparatorschaltung das Umpolen einer Stromquelle steuert, die an den Eingang (24) des Integrators angeschlossen ist.

## Claims

1. Comparator circuit (22, 23, 254, 256, 257) including an integrator (21, 242) and:
- a first transistor (251) which is fed from a current source (252), is connected to one pole (26) of the supply voltage and can be controlled in respect of its saturation voltage, its output being associated with a terminal of a capacitor (21) and an output of a second transistor (242) which is connected to the other pole (27) of the supply voltage and can be controlled in respect of its saturation voltage,
- an integrator input (24) which is associated with the other terminal of the capacitor (21) and the input of a third transistor (241) whose one output is associated with the input of the second transistor (242) and whose other output is associated with the input of the comparator circuit and the input of the current source (252) connected to the comparator circuit.

2. Comparator circuit in accordance with Claim 1, characterised in that, the first transistor (251) and the second transistor (242) are not saturated during the charging and discharging of the capacitor (21).

3. Comparator circuit in accordance with Claim 1 or 2, characterised in that, the first transistor (251) and the second transistor (242) are complementary transistors.

4. Comparator circuit in accordance with Claim 1, 2 or 3, characterised in that, the first transistor (251) has the function of a current mirror.

5. Comparator circuit in accordance with any one or more of the Claims 1 to 4, characterised in that, the first transistor (251) is of the PNP type and the second transistor (242) and the third transistor (241) are of the NPN type, wherein the collector of the first transistor is associated with the collector of the second transistor and the collector of the third transistor with the comparator circuit.

6. Comparator circuit in accordance with any one or more of the Claims 1 to 5, characterised in that, the integrator has a current controlled input (24).

7. Comparator circuit in accordance with Claim 6, characterised in that, the comparator circuit controls the reversal of the poles of a current source which is connected to the input (24) of the integrator.

## Revendications

1. Circuit comparateur (22, 23, 254, 256, 257) avec un intégrateur (21, 242) et
- un premier transistor (251) alimenté par une source de courant (252), connecté sur un pôle (26) de la tension de service et réglable jusqu'à la tension de saturation, dont la sortie est associée à une borne d'un condensateur (21) et à une sortie d'un second transistor (242) connecté à l'autre pôle (27) de la tension d'alimentation et réglable jusqu'à la tension de saturation,
- une entrée d'intégrateur (24) qui est associé à l'autre borne du condensateur (21) et à l'entrée d'un troisième transistor (241) dont l'une des sorties est associée à l'entrée dudit second transistor (242) et dont l'autre sortie est associée à l'entrée du circuit comparateur ainsi qu'à l'entrée de la source de courant (252) connectée audit circuit comparateur.

2. Circuit comparateur selon la revendication 1 **caractérisé en ce** que le premier transistor (251) et le second transistor (242) ne sont pas saturés lors de la charge et la décharge du condensateur (21).

3. Circuit comparateur selon l'une quelconque des revendications 1 ou 2 **caractérisé en ce** que le premier transistor (251) et le second transistor (242) sont des transistors complémentaires.

4. Circuit comparateur selon l'une quelconque des revendications 1, 2 ou 3 **caractérisé en ce** que ledit premier transistor (251) assure la fonction d'un miroir de courant.

5. Circuit comparateur selon l'une quelconque ou plusieurs des revendications 1 à 4 **caractérisé en ce** que le premier transistor est du type PNP et que les second (242) et troisième (241) transistors sont du type NPN, sachant que le collecteur du premier transistor est associé au collecteur du second transistor et que le collecteur du troisième transistor est associé au circuit comparateur.

6. Circuit comparateur selon l'une quelconque ou plusieurs des revendications 1 à 5 **caractérisé en ce** que l'intégrateur possède une entrée (24) commandée par le courant.

7. Circuit comparateur selon la revendication 6 **caractérisé en ce** que ledit circuit comparateur permet de commander l'inversion de la polarisation d'une source de courant qui est connectée à l'entrée (24) de l'intégrateur.
